# EUROPEAN PATENT APPLICATION

(11) **EP 4 589 743 A1**
(43) Date of publication of application: **23.07.2025**
(21) Application number: 23864812.5
(22) Date of filing: 15.09.2023
(51) Int. Cl.: H01M 50/204, H01M 10/48, H01M 50/507

(54) **BATTERY CELL, BATTERY MODULE, AND BATTERY PACK**

(30) Priority: 15.09.2022 CN 202222451774 U
(71) Applicant: BYD Company Limited, Shenzhen, Guangdong 518118 (CN)
(72) Inventor: CAI, Yaomin, Shenzhen, Guangdong 518118 (CN); ZHONG, Rijun, Shenzhen, Guangdong 518118 (CN); ZHU, Ruiyuan, Shenzhen, Guangdong 518118 (CN); FENG, Jiamao, Shenzhen, Guangdong 518118 (CN)
(74) Representative: Mathys & Squire
(86) International application number: PCT/CN2023/119187
(87) International publication number: WO 2024/056084

(57) **Abstract**

A battery cell (2000), a battery module, and a battery pack (1000). The battery cell (2000) comprises a battery cell body (200) and an optical fiber (10), wherein a plurality of grating temperature measuring points (11) are formed on the optical fiber (10), and the optical fiber (10) is arranged on the battery cell body (200).

## Description

### CROSS-REFERENCE TO RELATED APPLICATIONS

The present disclosure claims priority to Chinese Patent Application No. 202222451774.9, filed on September 15, 2022 and entitled "BATTERY CELL, BATTERY MODULE, AND BATTERY PACK". The entire content of the above-referenced application is incorporated herein by reference.

### FIELD

The present disclosure relates to the technical field of cells, and more specifically, to a cell, a battery module, and a battery pack.

### BACKGROUND

In the related art, a temperature of a battery is mainly detected through multiple thermistors. A relatively small number of data points are provided for temperature collection, which have a simple and limited arrangement form, and can be arranged only at an end portion of a cell. The collected data is simple and limited, and it is difficult to collect the highest temperature and the lowest temperature of the cell. In addition, data collection is susceptible to electromagnetic interference, resulting in data drift, low testing precision, and significant difficulty in arrangement.

### SUMMARY

The present disclosure is intended to resolve at least one of technical problems in the related art. Therefore, an objective of the present disclosure is to provide a cell. Grating temperature measurement points are arranged on a cell body, to perform temperature measurement on the cell, which has high temperature measurement precision, little environmental impact, reasonable space occupation, and high arrangement convenience.

The present disclosure further provides a battery module having the above cell.

The present disclosure further provides a battery pack having the above battery module.

The cell according to the present disclosure includes a cell body and an optical fiber. Multiple grating temperature measurement points are formed on the optical fiber. The optical fiber is arranged on the cell body.

In the cell according to the present disclosure, the grating temperature measurement points are arranged on the cell body, to perform temperature measurement on the cell. In this way, on the one hand, a quantity and arrangement positions of the grating temperature measurement points are more reasonable, data samples are more abundant, the temperature measurement of the cell is more accurate, and preparation is made for subsequent temperature control of the cell. On the other hand, the optical fiber has a small geometric size, is less restricted by a physical structure, has low arrangement difficulty, can be arranged without changing a structure of the cell, and are not affected by electromagnetic interference. In this way, collection precision is high, and data is accurate.

The battery module according to the present disclosure includes multiple cells described above.

The battery pack according to the present disclosure includes the above battery module.

Part of additional aspects and advantages of the present disclosure is provided in the following description. The part becomes apparent from the following description, or is learned through practice of the present disclosure.

### BRIEF DESCRIPTION OF THE DRAWINGS

FIG. 1 is a schematic diagram of a battery pack according to an embodiment of the present disclosure;
FIG. 2 is a schematic diagram of mating between a temperature measurement assembly and a cell according to a first embodiment of the present disclosure; and
FIG. 3 is a schematic diagram of mating between a temperature measurement assembly and a cell according to a second embodiment of the present disclosure.

In the drawings:
Battery pack 1000; Cell 2000;
Temperature measurement assembly 100, Cell body 200,
Optical fiber 10, Optical fiber temperature measurement point 11, First section 12, Second section 13,
Computer 20,
Housing 210, and Bare Cell 220.

### DETAILED DESCRIPTION

Embodiments of the present disclosure are described in detail below. Examples of the embodiments are shown in accompany drawings. Same or similar elements or elements having same or similar functions are denoted by same or similar reference numerals throughout the description. The embodiments described below with reference to the accompany drawings are exemplary and used only for explaining the present disclosure, and cannot be construed as a limitation on the present disclosure.

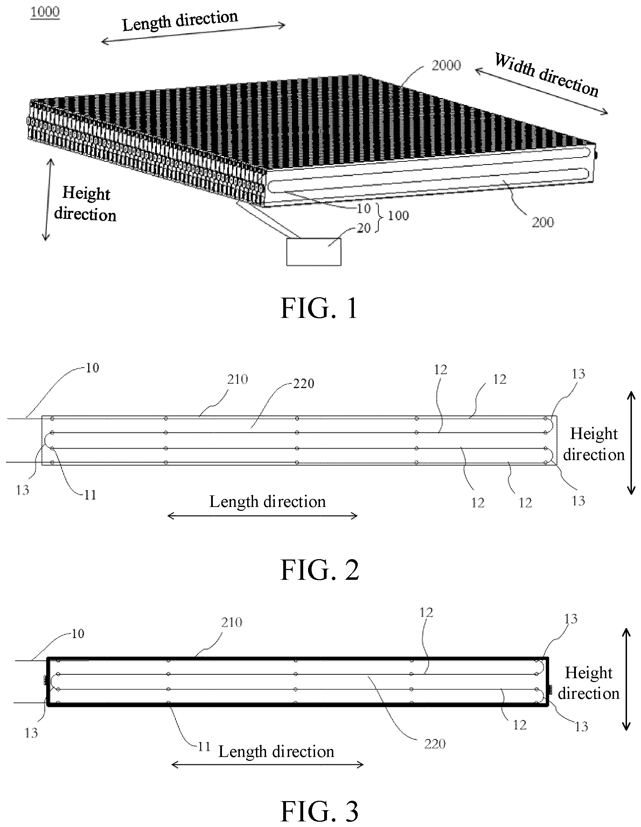

A cell 2000, a battery module, and a battery pack 1000 according to the embodiments of the present disclosure are described below with reference to FIG. 1 to FIG. 3.

As shown in FIG. 1, FIG. 2, and FIG. 3, the cell 2000 according to an embodiment of a first aspect of the present disclosure includes a cell body 200 and an optical fiber 10.

Multiple grating temperature measurement points 11 are formed on the optical fiber 10.

In the present disclosure, the optical fiber 10 is arranged on the cell body 200, and gratings are ruled on the optical fiber 10 in advance as the grating temperature measurement points 11. The optical fiber 10 may be in signal connection with a computer 20 arranged outside the cell 2000 to form a temperature measurement assembly 100. In other words, the temperature measurement assembly 100 includes the optical fiber 10 and the computer 20. The optical fiber 10 is arranged on the cell body 200. The computer 20 is connected to an input terminal and an output terminal of the optical fiber 10. The computer 20 includes at least a signal transmission source and a demodulator, to convert an optical signal into a temperature signal and realize temperature measurement of the cell body 200. It may be understood that the battery pack 1000 has multiple cells 2000. The battery pack 1000 further has a thermal management system for performing thermal management on the cells 2000. The computer 20 is arranged outside the cell 2000, and is constructed as part of the thermal management system.

It should be noted that a grating is an optical device composed of a large number of parallel slits with regularly changing spacings, for example, an equidistant grating of a same spacing width in the form of parallel slits. The above large number of parallel slits with regularly changing spacings are ruled onto a fiber core of the optical fiber 10 through photosensitivity of a material of the optical fiber 10, so that the grating is formed. However, flexible use of the gratings lies in that multi-point sensing can be achieved. In theory, countless gratings of different wavelengths may be ruled in one optical fiber 10 to achieve distributed monitoring of a same physical parameter or multiple physical parameters. The optical fiber 10 in which multiple gratings are ruled is formed as an optical fiber grating string. By precisely arranging a distance between two reflection points, a light wave signal that meets a condition is reflected by the grating, and a signal with another wavelength is substantially not reflected. Through connection to a demodulator of the grating, an optical wave wavelength of an independent emission wave emitted by a signal source may be measured. Once the grating is affected by a temperature change or a stress field change, a grating pitch changes, a wavelength of a reflected wave changes accordingly, and different wavelengths are emitted, to achieve temperature measurement functions of the grating temperature measurement points 11 based on the different wavelengths.

Based on the above, the grating temperature measurement points 11 are arranged in a region with severe temperature changes and a region where a temperature needs to be collected according to a size and thermal field distribution of the cell body 200 (for example, as shown in FIG. 2 and FIG. 3, multiple grating temperature measurement points 11 are equidistantly arranged in a height direction and a length direction of the cell body 200). In addition, the optical fiber 10 has a small geometric size, and has a diameter of only one hundred or hundreds of microns. In this way, not only a physical limitation caused by a stacked structure of a busbar and the cell body 200 can be overcome, but also a limitation is reduced, thereby realizing various forms of arrangement and reasonable arrangement of the grating temperature measurement points 11. Larger quantities indicate more abundant collected data, so that a highest temperature and a lowest temperature of the cell body 200 may be collected, and positions of the highest temperature point and the lowest temperature point may be determined. More abundant samples indicate more accurate temperature measurement of the cell 2000, which further facilitates subsequent temperature control of the cell body 200. Moreover, temperature measurement through the optical fiber 10 is not affected by electromagnetic interference, so that the data is more accurate and collection precision is higher.

In the cell 2000 according to the embodiments of the present disclosure, the grating temperature measurement points 11 are arranged on the cell body 200, to perform the temperature measurement on the cell body 200. In this way, on the one hand, the quantity and arrangement positions of the grating temperature measurement points 11 may be more reasonable, and the data samples may be more abundant, which facilitates temperature control of the cell body 200. On the other hand, the optical fiber 10 has a small geometric size, is less restricted by a physical structure, has low arrangement difficulty, can be arranged without changing a structure of the cell body 200, and is not affected by electromagnetic interference. In this way, collection precision is high, and data is accurate.

As shown in FIG. 2 and FIG. 3, according to some embodiments of the present disclosure, the cell body 200 includes a housing 210 and a bare cell 220 arranged in the housing 210. The optical fiber 10 is arranged on the housing 210 or the bare cell 220.

The cell body 200 and the optical fiber 10 may be fixed in multiple manners, for example, by using a thermally conductive structural adhesive, or the optical fiber 10 is fixed to the bare cell 220 or the housing 210 through arrangement of a fixed support, a fixed groove, or the like.

Exemplarily, as shown in FIG. 3, the optical fiber 10 is arranged on a side surface of the housing 210 facing the bare cell 220, and/or the optical fiber 10 is arranged on a side surface of the housing 210 facing away from the bare cell 220. Specifically, the side surface may be defined jointly by the height direction and the length direction shown in FIG. 1.

In some embodiments, the housing 210 has a large cell surface facing or facing away from the bare cell 220. The optical fiber 10 is arranged on the large cell surface. Alternatively, an outer surface of the bare cell 220 may have a large cell surface. The optical fiber 10 may be arranged on the large cell surface of the bare cell 220. It may be understood that the bare cell 220, the housing 210, or the cell body 200 has multiple surfaces. The large cell surface refers to a surface with a largest area among all surfaces of the bare cell 220, the housing 210, or the cell body 200.

Based on the above, a temperature of the bare cell 220 or the housing 210 may be measured through the optical fiber 10, to directly or indirectly achieve temperature measurement of the cell body 200, and improve data precision. The optical fiber 10 is arranged relative to the large cell surface. The quantity and the positions of the grating temperature measurement points 11 may be reasonably set according to thermal field distribution. A relatively large heat generation amount of the large cell surface indicates more accurate measurement.

In some embodiments, a groove or a fixed support may be arranged on the housing 210. The optical fiber 10 is embedded in the groove or arranged on the fixed support. Herein, the groove or the fixed support may be arranged on an inner side or an outer side of the housing 210. Correspondingly, the optical fiber 10 may be arranged in the groove or on the fixed support located inside the housing 210, or the optical fiber 10 may be arranged in the groove or on the fixed support located on the surface of the housing 210 facing the bare cell 220. The optical fiber 10 may be further arranged in the groove or on the fixed support on the surface of the housing 210 facing away from the bare cell 220. In other words, the optical fiber 10 is arranged on the outer side of the housing 210. A specific arrangement position of the optical fiber 10 is not limited herein. In some other embodiments, the optical fiber 10 may be arranged on the side surface of the housing 210 facing the bare cell 220 or arranged on the bare cell 220. In this case, the optical fiber 10 may be fixed to the housing 210 or the bare cell 220 by using a thermally conductive structural adhesive.

It should be noted that optical fiber 10 also has relatively high tolerance to an electrolyte. Therefore, the optical fiber may be arranged in the housing 210, and may detect a temperature field more accurately. In addition, the optical fiber 10 has the small geometric size and high scalability, so that the position may be reasonably set according to an arrangement requirement.

As shown in FIG. 2 and FIG. 3, according to some embodiments of the present disclosure, an input terminal and an output terminal of the optical fiber 10 are located at a same end of the cell body 200 and extend out of the cell body 200, to connect to the computer 20. In this way, a wire may extend out from a same side of the input terminal and the output terminal, to reduce a total length of the optical fiber 10, which may further reduce costs.

In some embodiments, the optical fiber 10 is arranged on at least one end surface in the length direction or a width direction of the cell body 200 and extends along the width direction or the length direction. In addition, the optical fiber 10 is configured to be bent. Projections of the optical fiber 10 along the height direction shown in FIG. 1 at least partially overlap. Specifically, the optical fiber 10 is arranged on at least one end surface in the length direction of the cell body 200, the optical fiber 10 extends along the length direction, and the optical fiber 10 is configured to be bent; and/or the optical fiber 10 is arranged on at least one end surface in the width direction of the cell body 200, the optical fiber 10 extends along the width direction, and the optical fiber 10 is configured to be bent. Through such an arrangement of wire, a quantity of bending times of the optical fiber 10 may be reduced while meeting a condition that the optical fiber 10 covers the large cell surface of the bare cell 220, thereby reducing a conductivity loss of the optical fiber 10, and decreasing a probability of breakage of the extended wire of the optical fiber 10, to improve the measurement precision and operating stability and increase a service life of the temperature measurement assembly 100 composed of the optical fiber 10.

Herein, as shown in FIG. 2 and FIG. 3, exemplarily, a surface defined by the optical fiber 10 in the length direction and the height direction of the cell body 200 is arranged in a bow shape. In other words, the optical fiber 10 is arranged at an end of the cell body 200 along the length direction shown in FIG. 1 and extends to an other end of the cell body 200, then the optical fiber 10 is bent once along the height direction shown in FIG. 1, and the optical fiber 10 continuously extends along the length direction shown in FIG. 1 from the other end of the cell body 200 to the end of the cell body 200 after being bent, and then is bent again in the height direction shown in FIG. 1. The above process may be repeated multiple times to allow the optical fiber 10 to extend in the length direction multiple times and be bent in the height direction, so that the projections of the optical fibers 10 in the height direction at least partially overlap and are arranged in the "bow" shape at the end portion of the cell body 200. In this way, more grating temperature measurement points 11 are arranged in the width direction or the length direction of the cell body 200, thereby improving precision and an effect of the temperature measurement. The grating temperature measurement points 11 may be reasonably arranged for thermal field distribution, which is not limited herein.

In some embodiments, the grating temperature measurement points 11 are arranged in an array, which may be arranged in rows in the length direction shown in FIG. 1 and arranged in columns in the height direction, so that multiple grating temperature measurement points 11 are distributed at intervals in multiple temperature measurement regions, to improve temperature measurement precision of each of the temperature measurement regions, and help obtain numerical values and positions of a highest temperature point and a lowest temperature point.

In some embodiments, the optical fiber 10 includes first sections 12 and second sections 13. The first sections 12 are constructed as multiple first sections extending in a first direction and arranged at intervals in a second direction. Each of the first sections 12 is provided with a same quantity of grating temperature measurement points 11. The second sections 13 are arranged ends of two adjacent first sections 12 which are on a same side and connect the two first sections 12. The first direction is a length direction or a width direction. The second direction is a height direction. In other words, the first sections 12 extend in the length direction shown in FIG. 1, the multiple first sections 12 are distributed over the large cell surface of the bare cell 220, and projections of the multiple first sections 12 along the height direction of the cell body 200 are arranged to overlap. Each first section 12 is provided with multiple grating temperature measurement points 11, and the quantity of grating temperature measurement points 11 on each first section 12 is the same, to achieve temperature detection at multiple heights of the large cell surface of the bare cell 220. In addition, the second sections 13 extend in the height direction shown in FIG. 1 and are connected to ends of two adjacent first sections 12 which are on a same side, so that the first sections 12 are successively and orderly connected, to facilitate arrangement of the optical fiber 10. In this way, the optical fiber 10 is arranged as a whole at the end of the cell body 200 along the length direction shown in FIG. 1 and extends to the other end of the cell body 200, then the optical fiber 10 is bent once along the height direction shown in FIG. 1, and the optical fiber 10 continuously extends along the length direction shown in FIG. 1 from the other end of the cell body 200 to the end of the cell body 200 after being bent, and then is bent again in the height direction shown in FIG. 1. The above process may be repeated multiple times, so that more grating temperature measurement points 11 are arranged in the width direction or the length direction of the cell body 200, thereby improving the precision and the effect of the temperature measurement.

In some embodiments, a distance between two adjacent grating temperature measurement points 11 on a same first section 12 is the same, so that the grating temperature measurement points 11 are uniformly distributed on the first section 12, and the temperature measurement is more accurate and more precise.

In some embodiments, a distance between two grating temperature measurement points 11 located on two adjacent first sections 12 and directly facing each other in the second direction is the same. In other words, a distance between every two adjacent first sections 12 is equal, and the quantity of grating temperature measurement points 11 on the same first section 12 is the same as the distance between two adjacent grating temperature measurement points 11. Therefore, the grating temperature measurement points 11 located on two adjacent first sections 12 are arranged directly facing each other in the second direction. In this case, distances between multiple grating temperature measurement points 11 on the above two adjacent first sections 12 are all the same, to allow the grating temperature measurement points 11 to be uniformly distributed over the optical fiber 10, thereby improving the precision and the effect of the temperature measurement.

As shown in FIG. 1, the battery module according to an embodiment of a second aspect of the present disclosure includes multiple cells 2000 in the above embodiments.

The above optical fiber 10 may be arranged on the cell body 200 of each of the cells 2000. Multiple relatively short optical fibers 10 are connected to the computer 20, or a relatively long optical fiber 10 may be adopted and successively arranged on the multiple cells 2000, to achieve an arrangement form in which the multiple cells 2000 share one optical fiber 10. Furthermore, a same optical fiber 10 may be arranged for all cell bodies 200 in the entire battery module to later detect a temperature field of the entire battery module and trigger different thermal management policies, which may also achieve position confirmation and numerical value confirmation of highest temperature points and lowest temperature points of a single cell body 200 and the entire battery pack 1000, and the like.

In the battery module according to the embodiment of the present disclosure, the above cell 2000 is used, so that a large amount of data detection at a position where the temperature measurement is required may be achieved, and the measured data does not produce data drift caused by the electromagnetic interference, and has higher accuracy. In addition, the temperature field of the entire battery module may be measured, to monitor the entire battery module in real time, which facilitates triggering of a supporting thermal management strategy, and improves operating stability and usage safety of the battery module.

In some embodiments, the battery module further includes a busbar. The output terminal and the input terminal of the optical fiber 10 are integrated into the busbar.

Exemplarily, one optical fiber 10 may be arranged for each cell 2000, and then led out from a side surface as a whole or integrated into the busbar, to extend a wire through a gap of an existing structure or the existing structure, which causes a smaller change to the overall structure of the battery module and may effectively reduce costs.

In the battery pack 1000 according to an embodiment of a third aspect of the present disclosure, the battery module in the above embodiments is adopted, which has the same technical effect as the above battery module. The details are not described herein again.

In the description of this specification, descriptions provided with reference to terms such as "an embodiment", "some embodiments", "an exemplary embodiment", "an example", "a specific example", and "some examples" mean that specific features, structures, materials, or characteristics described with reference to the embodiment or the example are included in at least one embodiment or example of the present disclosure. In this specification, exemplary descriptions of the above terms do not necessarily refer to the same embodiment or example. In addition, the described specific features, structures, materials, or characteristics may be combined in a proper manner in any one or more embodiments or examples.

Although the embodiments of the present disclosure have been shown and described, a person of ordinary skill in the art may understand that various changes, modifications, replacements, and variations may be made to the embodiments without departing from the principle and spirit of the present disclosure, and the scope of the present disclosure is defined by the appended claims and their equivalents.

## Claims

1. A cell (2000), comprising:
a cell body (200) and an optical fiber (10), a plurality of grating temperature measurement points (11) being formed on the optical fiber (10), and the optical fiber (10) being arranged on the cell body (200).

2. The cell (2000) according to claim 1, wherein the cell body (200) comprises a housing (210) and a bare cell (220) arranged in the housing (210), the optical fiber (10) being arranged on the housing (210) or the bare cell (220).

3. The cell (2000) according to claim 1 or 2, wherein the optical fiber (10) is arranged on a side surface of the housing (210) facing the bare cell (220), the surface being a large cell surface of the housing; and/or
the optical fiber (10) is arranged on a side surface of the housing (210) facing away from the bare cell (220), the surface being the large cell surface of the housing.

4. The cell (2000) according to any of claims 2 to 3, wherein an outer surface of the bare cell (220) has a large cell surface; and the optical fiber (10) is arranged on the large cell surface.

5. The cell (2000) according to any of claims 2 to 4, wherein a groove is provided on the housing (210); and the optical fiber (10) is embedded in the groove.

6. The cell (2000) according to any of claims 1 to 5, wherein an input terminal and an output terminal of the optical fiber (10) are at a same end of the cell body (200) and extend out of the cell body (200).

7. The cell (2000) according to any of claims 1 to 6, wherein the optical fiber (10) is arranged on at least one end surface in a length direction of the cell body (200); the optical fiber (10) extends along the length direction; and the optical fiber (10) is configured to be bent; and/or
the optical fiber (10) is arranged on at least one end surface in a width direction of the cell body (200); the optical fiber (10) extends along the width direction; and the optical fiber (10) is configured to be bent.

8. The cell (2000) according to any of claims 1 to 7, wherein the optical fiber (10) is arranged in a bow shape on a surface defined by the length direction and a height direction of the cell body (200).

9. The cell (2000) according to any of claims 1 to 8, wherein the grating temperature measurement points (11) are arranged in an array.

10. The cell (2000) according to claim 9, wherein the optical fiber (10) comprises:
first sections (12), the first sections (12) being constructed as a plurality of first sections extending in a first direction and arranged at intervals in a second direction, and each of the first sections (12) being provided with a same quantity of grating temperature measurement points (11); and
second sections (13), the second sections (13) being arranged at ends of two adjacent first sections (12) which are on a same side and connecting the two first sections (12), the first direction being a length direction or a width direction, and the second direction being a height direction.

11. The cell (2000) according to claim 10, wherein a distance between two adjacent grating temperature measurement points (11) on a same first section is the same.

12. The cell (2000) according to claim 10, wherein a distance between two grating temperature measurement points (11) located on two adjacent first sections and directly facing each other in the second direction is the same.

13. A battery module, comprising: a plurality of cells (2000) according to any of claims 1 to 12.

14. The battery module according to claim 13, further comprising a busbar, the output terminal and the input terminal of the optical fiber (10) being integrated into the busbar.

15. A battery pack (1000), comprising the battery module according to claim 13 or 14.

16. The battery pack (1000) according to claim 15, further comprising a computer (20), the computer (20) being adapted to connect to the output terminal and the input terminal of the optical fiber (10).
